# EUROPEAN PATENT APPLICATION

(11) **EP 4 545 615 A1**
(43) Date of publication of application: **30.04.2025**
(21) Application number: 24208245.1
(22) Date of filing: 23.10.2024
(51) Int. Cl.: C09G 1/02, C09K 3/14

(54) **POLISHING COMPOSITION FOR SEMICONDUCTOR PROCESS AND METHOD OF MANUFACTURING SUBSTRATE USING SAME**

(30) Priority: 25.10.2023 KR 20230143990
(71) Applicant: SK enpulse Co., Ltd., Pyeongtaek-si, Gyeonggi-do 17784 (KR)
(72) Inventor: PARK, HAN TEO, 03142 Seoul (KR); HAN, DEOK SU, 03142 Seoul (KR); LEE, Hyung-joo, 03142 Seoul (KR); CHOI, Yongsoo, 03142 Seoul (KR)
(74) Representative: BCKIP Part mbB

(57) **Abstract**

Disclosed is a polishing composition for a semiconductor process, including polishing particles, iron ions, and an iron ion stabilizer, in which the iron ion stabilizer comprises two or more carboxyl groups and the polishing composition has electrical conductivity of 200 µS/cm to 800 µS/cm. The polishing composition may polish a substrate surface including a tungsten pattern film having a fine pitch more smoothly.

## Description

### CROSS-REFERENCE TO RELATED APPLICATIONS

This application claims the priority of Korean Patent Application No. 10-2023-0143990 filed on October 25, 2023 before the Korean Intellectual Property Office.

### BACKGROUND

### 1. Field

The present disclosure relates to a polishing composition for a semiconductor process and a method of manufacturing a substrate using the same.

### 2. Description of the Background

As semiconductor devices become more miniaturized and denser, finer pattern formation techniques are being used, so that the surface structure of semiconductor devices becomes more complex and defects resulted from step heights of interlayer films occur frequently. In manufacturing semiconductor devices, chemical mechanical polishing (hereinafter referred to as "CMP") is employed as a planarization process to remove a step height from a certain film formed on a substrate.

In the CMP process, the substrate is pressed and rotated, while a slurry is supplied to a polishing pad and the surface thereof is polished. Depending on the stage of the process, the object to be planarized varies, and the properties of the slurry applied thereto also differ.

Polishing after metal wiring is formed requires maintaining a sufficient polishing rate and polishing speed while minimizing dishing or erosion.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, the polishing composition for a semiconductor process includes polishing particles, iron (Fe) ions, and an iron (Fe) ion stabilizer.The iron ion stabilizer may include two or more carboxyl groups.

The polishing composition may have electrical conductivity of 200 µS/cm to 800 µS/cm.

The iron ions may be divalent or trivalent.

The iron ions may be derived from a compound selected from the group consisting of iron chloride, iron nitrate, iron sulfate, iron perchlorate, iron acetate, iron citrate, and Fe(III)-EDTA (ethylenediaminetetraacetic acid).

The iron ion stabilizer may be selected from the group consisting of ethanedioic acid, propanedioic acid, butanedioic acid, pentanedioic acid, hexanedioic acid, and heptanedioic acid.

In the polishing composition, the weight ratio of the content of the iron ion stabilizer relative to the content of the iron ions may be 3 to 50.

The polishing composition may include 1*10⁻⁴ wt% to 5*10⁻³ wt% of the iron ions.

The polishing particles may include metal oxide particles, silicon oxide particles, or a combination thereof.

The polishing particles may include 70 wt% or more of colloidal silica based on a total weight of the polishing particles.

The polishing composition may include 1 wt% to 10 wt% of polishing particles based on a total weight of the polishing composition.

The polishing composition may include: a first polishing particle filtered through a primary filter having a pore size of 0.05 µm to 2 µm; a second polishing particle filtered through a secondary filter having a pore size of at most 0.9 times of the pore size of the primary filter; and a third polishing particle filtered through a teriary filter having a pore size of at most 1.5 times of the pore size of the secondary filter.

The polishing composition may further include a polyglycerin-based compound.

A weight average molecular weight of the polyglycerin-based compound may be 300 g/mol to 1,200 g/mol.

The polishing composition may include 0.001 wt% to 0.1 wt% of the polyglycerin-based compound based on a total weight of the polishing composition.

The polishing selectivity of the polishing composition for a silicon oxide film relative to a tungsten film may be 1 to 5.

The polishing composition may have a pH of 1.5 to 4.5.

In the polishing composition, the number of particles with a diameter exceeding 1 µm may be 80/ml or less as measured by a large particle counter (LPC) per unit volume.

The polishing composition may further include an additive selected from the group consisting of an oxidant, an acid component, a pH adjuster, a dispersant, a polishing rate enhancer, a polishing regulator, a polishing pad protector, and a preservative.

In another general aspect, the method of manufacturing a substrate includes polishing the substrate using the polishing composition described above as a slurry.

The polishing may include: contacting the substrate with a polishing pad and the polishing composition described above supplied from a spray nozzle; and rotating a polishing head fixing the substrate and a platen, to which the polishing pad is attached.

During the polishing, a pressure of 6.89 kPa to 48.26 kPa may be applied to the substrate.

Other features and aspects will be apparent from the following detailed description and the claims.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of this disclosure. Hereinafter, while embodiments of the present disclosure will be described in detail, it is noted that examples are not limited to the same.

As used herein, the terms "about," "substantially," and the like, are used to mean at or near the numerical value when manufacturing and material tolerances inherent in the meanings stated are presented, and are used to prevent unscrupulous infringers from unfairly exploiting the disclosure in which exact or absolute values are stated to aid understanding of embodiments of the present disclosure.

Herein, the term "combination thereof' included in the expressions in the Markush format refers to a mixture or combination of one or more selected from the group consisting of components described in the expressions in the Markush format, and means including one or more selected from the group consisting of the components.

Herein, the description of "A and/or B" means "A, B, or A and B."

Herein, terms such as "first" and "second", or "A" and "B" are used to distinguish the same terms from each other unless otherwise specified.

Herein, the meaning of B being located on A is that B may be located in contact with A or that B may be located on A with another layer interposed therebetween, and is not limited to B being located in contact with the surface of A.

Herein, singular expressions are interpreted to include the singular or plural as interpreted by the context, unless otherwise specified.

The term "--based compound" includes "∼ compound" and derivatives thereof. By way of example, a polyglycerin-based compound refers to a polyglycerin compound and derivatives of the polyglycerin compound.

The object of the present disclosure is to provide a polishing composition for a semiconductor process capable of smoothly polishing a substrate surface including a tungsten pattern film having a fine pitch.

A process of polishing a substrate surface including a tungsten pattern film may be performed in two steps as follows. A primary tungsten polishing process of exposing a tungsten pattern film and an insulating layer by polishing a tungsten bulk layer and a secondary tungsten polishing process of reducing a step height between the tungsten pattern film and the insulating layer may be carried out.

As the pitch of the tungsten pattern film decreases, the frequency of defect issues occurring in the secondary tungsten polishing process increases. Specifically, defects such as increased step height of the contact pattern, misalignment with upper contact pattern, etc. may occur more frequently.

The polishing composition according to the present disclosure may provide a smooth and defect-reduced polished surface even when polishing a substrate surface including a tungsten pattern film having a fine pitch.

Hereinafter, a detailed description will be given of the present disclosure.

### Polishing composition

### Iron ions and iron ion stabilizer

The polishing composition for a semiconductor process according to the present disclosure includes polishing particles, iron ions, and an iron ion stabilizer.

Iron ions may be derived from compounds including not only common iron ionic compounds, but also iron ion complexes and hydrates of iron ion complexes and iron ion compounds.

Iron ions may serve to promote oxidation of tungsten during polishing of a tungsten pattern film. Also, iron ions may contribute to the polishing composition having a controlled zeta potential. Thereby, iron ions may serve to prevent the polishing composition from excessively polishing an insulating film, particularly a silicon oxide film. In addition, the polishing properties of the polishing composition for a tungsten film may be improved, and the occurrence of a step height on the polished substrate due to excessive polishing of the silicon oxide film may be suppressed.

The iron ions may be divalent (Fe²⁺) or trivalent (Fe³⁺).

The iron ions may be derived from, but are not limited to, for example, iron chloride, iron nitrate, iron sulfate, iron perchlorate, iron acetate, iron citrate, Fe(III)-EDTA (ethylenediaminetetraacetic acid), etc.

Meanwhile, iron ions in the polishing composition may have relatively high reactivity. Due to such properties, iron ions may not participate in reaction that oxidizes the tungsten film but may become a reactant in a side reaction. The iron ion stabilizer may serve to stabilize iron ions in the polishing composition, thereby helping to enable a greater number of iron ions to be used in the tungsten film polishing process.

The iron ion stabilizer may include two or more carboxyl groups. The carboxyl group may form a coordination bond with iron ions, controlling the reactivity of iron ions in the polishing composition.

The iron ion stabilizer may be selected from the group consisting of ethanedioic acid, propanedioic acid, butanedioic acid, pentanedioic acid, hexanedioic acid, and heptanedioic acid. The iron ion stabilizer may be selected from the group consisting of ethanedioic acid, propanedioic acid, and butanedioic acid.

In the present disclosure, the weight ratio of the content of iron ions and the content of iron ion stabilizer may be adjusted within a preset range. Thereby, a sufficient number of iron ion compounds may be stabilized in the polishing composition, and the polishing properties of the polishing composition for a tungsten film may be effectively improved.

In the polishing composition for a semiconductor process, the weight ratio of the content of the iron ion stabilizer relative to the content of the iron ions may be 3 to 50. The ratio may be 5 or more. The ratio may be 10 or more. The ratio may be 14 or more. The ratio may be 40 or less. The ratio may be 30 or less. As such, the iron ion stabilizer may sufficiently control the reactivity of iron ions in the polishing composition, and it is possible to suppress an excessive decrease of the pH of the polishing composition by the iron ion stabilizer.

The polishing composition for a semiconductor process may include 1*10⁻⁴ wt% to 5*10⁻³ wt% of iron ions. The polishing composition may include 3*10⁻⁴ wt% or more of iron ions. The polishing composition may include 5*10⁻⁴ wt% or more of iron ions. The polishing composition may include 4*10⁻³ wt% or less of iron ions. The polishing composition may include 3*10⁻³ wt% or less of iron ions. As such, the polishing properties of the polishing composition for the tungsten film and the silicon oxide film may be controlled together. Thereby, the substrate surface including a finely formed tungsten pattern film may be polished more smoothly.

The iron ion content of the polishing composition for a semiconductor process may be measured by ICP-OES (inductively coupled plasma optical emission spectroscopy).

### Polyglycerin-based compound

The polishing composition for a semiconductor process may further include a polyglycerin-based compound. The polyglycerin-based compound may act as a surfactant in the polishing composition, facilitating removal of remaining particles or polishing pad debris from the surface of the substrate to be polished. Furthermore, the polyglycerin-based compound may contribute to suppressing scratches caused by the polishing particles on the polished surface by preventing the polishing particles of the present disclosure from agglomerating with each other to form large particles during the polishing process.

A weight average molecular weight of the polyglycerin-based compound may be in the range of 300 g/mol to 1,200 g/mol. The weight average molecular weight may be 400 g/mol or more. The weight average molecular weight may be 500 g/mol or more. The weight average molecular weight may be 1,100 g/mol or less. The weight average molecular weight may be 1,000 g/mol or less. As such, foreign substances may be prevented from being adsorbed on the surface of the substrate to be polished, and dispersibility of the polishing particles may be effectively improved.

The weight average molecular weight of the polyglycerin-based compound may be measured by GPC (gel permeation chromatography).

The polishing composition may include 0.001 wt% to 0.1 wt% of the polyglycerin-based compound. The polishing composition may include 0.003 wt% or more of the polyglycerin-based compound. The polishing composition may include 0.005 wt% or more of the polyglycerin-based compound. The polishing composition may include 0.07 wt% or less of the polyglycerin-based compound. The polishing composition may include 0.05 wt% or less of the polyglycerin-based compound. The polishing composition may include 0.03 wt% or less of the polyglycerin-based compound. As such, organic particles remaining on the substrate surface may be easily removed. Furthermore, the number of defects occurring on the surface of the substrate to be polished may be reduced to a predetermined level or less.

### Polishing particles

The polishing particles may include metal oxide particles and/or silicon oxide particles. The polishing particles may include silica. The polishing particles may include colloidal silica.

The polishing particles may include 70 wt% or more of colloidal silica. The polishing particles may include 80 wt% or more of colloidal silica. The polishing particles may include 90 wt% or more of colloidal silica. The polishing particles may be colloidal silica.

The polishing particles may have a positive surface charge. The polishing particles may be surface-modified to have a positive surface charge. The polishing particles may be surface-modified with a compound having an amine group. The polishing particles may be surface-modified with aminosilane.

For example, the aminosilane may be selected from the group consisting of 3-aminopropyltriethoxysilane, bis[(3-triethoxysilyl)propyl]amine, 3-aminopropyltrimethoxysilane, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, and N-[3-(trimethoxysilyl)propyl]butylamine.

The polishing composition for a semiconductor process may include 15 ppm (by weight) to 200 ppm (by weight) of aminosilane. The polishing composition for a semiconductor process may include 20 ppm (by weight) or more of aminosilane. The polishing composition for a semiconductor process may include 25 ppm (by weight) or more of aminosilane. The polishing composition for a semiconductor process may include 30 ppm (by weight) or more of aminosilane. The polishing composition for a semiconductor process may include 150 ppm (by weight) or less of aminosilane. The polishing composition for a semiconductor process may include 100 ppm (by weight) or less of aminosilane. The polishing composition for a semiconductor process may include 70 ppm (by weight) or less of aminosilane. The polishing composition for a semiconductor process may include 50 ppm (by weight) or less of aminosilane. As such, the surface of the substrate to be polished may be polished more smoothly and improved dispersibility may be exhibited. Although residues of the surface modifier may be generated at the same time, the residues may be effectively suppressed from being adsorbed on the polished surface.

The polishing composition for a semiconductor process may include 1 wt% to 10 wt% of polishing particles. The polishing composition for a semiconductor process may include 2 wt% or more of polishing particles. The polishing composition for a semiconductor process may include 8 wt% or less of polishing particles. The polishing composition for a semiconductor process may include 5 wt% or less of polishing particles. As such, the polishing composition may stably suppress agglomeration of polishing particles while having excellent polishing rate on the polished surface.

The average particle diameter of the polishing particles may be 20 nm or more. The particle diameter thereof may be 30 nm or more. The particle diameter thereof may be 40 nm or more. The particle diameter thereof may be 70 nm or less. The particle diameter thereof may be 60 nm or less. The particle diameter thereof may be 50 nm or less. As such, the polishing composition may stably control the frequency of occurrence of defects on the polished surface while exhibiting excellent polishing rate on the polished surface.

Here, the average particle diameter refers to an average diameter of primary particles of the polishing particles.

In the present disclosure, the content of large particles in the polishing particles may be reduced to a predetermined level or less. Thereby, scratches caused by polishing particles on the polished surface, for example on the silicon oxide film, may be stably suppressed.

The LPC (large particle counter) measurement of polishing particles may be performed using a particle size analyzer by applying a crude solution of the polishing composition. The measurement conditions are set to Sensor Model LE400-05, a dilution factor of 1.53, a flow pump factor of 15 ml/min, and a sample vessel of 12 ml. For example, the particle size analyzer may be an AccuSizer 780 model from Entegris.

The number of particles with a diameter exceeding 1 µm in the polishing composition may be 80/ml or less as measured by LPC (large particle counter) per unit volume. The number of particles with a diameter exceeding 1 µm in the polishing composition may be 70/ml or less as measured by LPC per unit volume. The number of particles with a diameter exceeding 1 µm in the polishing composition may be 40/ml or less as measured by LPC per unit volume. The number of particles with a diameter exceeding 1 µm in the polishing composition may be 30/ml or less as measured by LPC per unit volume. The number of particles with a diameter exceeding 1 µm in the polishing composition may be 0.8/ml or more as measured by LPC per unit volume.

The number of particles with a diameter exceeding 5 µm in the polishing composition may be 6/ml or less as measured by LPC per unit volume. The number of particles with a diameter exceeding 5 µm in the polishing composition may be 4/ml or less as measured by LPC per unit volume. The number of particles with a diameter exceeding 5 µm in the polishing composition may be 2.5/ml or less as measured by LPC per unit volume. The number of particles with a diameter exceeding 5 µm in the polishing composition may be 0.4/ml or more as measured by LPC per unit volume.

The number of particles with a diameter exceeding 10 µm in the polishing composition may be 2/ml or less as measured by LPC per unit volume. The number of particles with a diameter exceeding 10 µm in the polishing composition may be 1/ml or less as measured by LPC per unit volume. The number of particles with a diameter exceeding 10 µm in the polishing composition may be 0.1/ml or more as measured by LPC per unit volume.

As such, the number of defects occurring on the polished surface may be stably reduced to a predetermined level or less.

In order to control the content of large particles in the polishing particles within a preset range according to the present disclosure, filtered polishing particles may be applied to the polishing composition.

Filtering of the polishing particles may be performed through one filter. Filtering of the polishing particles may be performed through two or more filters.

When two or more filters are used, the filters may have pores of different sizes or pores of the same size.

The polishing particles may be filtered through a primary filter. The pore size of the primary filter may be 0.05 µm to 2 µm. The pore size thereof may be 0.08 µm or more. The pore size thereof may be 1 µm or less. The pore size thereof may be 0.5 µm or less. The pore size thereof may be 0.3 µm or less.

The polishing particles may be filtered in the order of a primary filter and a secondary filter. The pore size of the secondary filter may be at most 0.9 times the pore size of the primary filter. The pore size of the secondary filter may be at most 0.8 times the pore size of the primary filter. The pore size of the secondary filter may be at least 0.3 times the pore size of the primary filter. The pore size of the secondary filter may be at least 0.5 times the pore size of the primary filter.

The polishing particles may be filtered in the order of the primary filter, the secondary filter, and a tertiary filter. The pore size of the tertiary filter may be at most 1.5 times the pore size of the secondary filter. The pore size of the tertiary filter may be at most 1.2 times the pore size of the secondary filter. The pore size of the tertiary filter may be at least 0.5 times the pore size of the secondary filter. The pore size of the tertiary filter may be at least 0.8 times the pore size of the secondary filter.

After filtering in the order of the primary filter, the secondary filter, and the tertiary filter, the polishing particles may be further filtered using another filter.

For example, the filter may be a filter from Saehan Green or a filter from MYCROPORE CORPORATION.

When the polishing composition passing through each of the aforementioned one or more filters once, it is defined as one cycle, the polishing particles may be filtered by circulating the polishing composition for one or more cycles. The polishing particles may be filtered by circulating the polishing composition for two or more cycles. The polishing particles may be filtered by circulating the polishing composition for ten or fewer cycles. The polishing particles may be filtered by circulating the polishing composition for five or fewer cycles.

As such, it is possible to stably suppress the occurrence of defects on the silicon oxide film surface caused by large particles during the polishing process.

### Other additives

The polishing composition for a semiconductor process may further include other additives. Additives are not limited so long as they are commonly used in the CMP field. For example, the additive may be at least one selected from the group consisting of an oxidant, an acid component, a pH adjuster, a dispersant, a polishing rate enhancer, a polishing regulator, a polishing pad protector, and a preservative.

The polishing composition for a semiconductor process may further include an oxidant. The oxidant serves to oxidize a metal such as tungsten, creating an environment in which the substrate surface may be more easily planarized, and plays a role in improving the polishing speed and etching speed.

The oxidant may be selected from the group consisting of hydrogen peroxide, urea hydrogen peroxide, urea, percarbonates, periodic acid, periodates, perchloric acid, perchlorates, perbromic acid, perbromates, perboric acid, perborates, permanganic acid, permanganates, persulfates, bromates, chlorates, chlorites, chromates, iodates, iodic acid, ammonium persulfate, benzoyl peroxide, calcium peroxide, barium peroxide, sodium peroxide, and urea peroxide.

The polishing composition for a semiconductor process may include 0.01 wt% to 5 wt% of the oxidant. As such, the polishing composition may exhibit excellent polishing properties for a metal and suppressing a formation of an oxide film on a metal to be polished during the polishing process.

The polishing composition for a semiconductor process may further include an acid component. The acid component may be selected from the group consisting of, for example, hydrochloric acid, phosphoric acid, sulfuric acid, hydrofluoric acid, bromic acid, iodic acid, formic acid, malonic acid, maleic acid, oxalic acid, acetic acid, adipic acid, citric acid, propionic acid, fumaric acid, lactic acid, salicylic acid, pimelic acid, benzoic acid, succinic acid, phthalic acid, butyric acid, glutaric acid, glutamic acid, glycolic acid, aspartic acid, tartaric acid, and salts thereof.

The polishing composition for a semiconductor process may further include a pH adjuster. The pH adjuster may be selected from the group consisting of, for example, ammonia, aminomethylpropanol, tetramethylammonium hydroxide, potassium hydroxide, sodium hydroxide, magnesium hydroxide, rubidium hydroxide, cesium hydroxide, sodium hydrogen carbonate, sodium carbonate, and imidazole.

The polishing composition for a semiconductor process may further include a dispersant.

The dispersant may serve to prevent agglomeration of polishing particles in the polishing composition and disperse the polishing particles more uniformly. A cationic dispersant may serve to positively increase a zeta potential of the polishing composition, and an anionic dispersant may serve to negatively decrease the zeta potential of the polishing composition.

The dispersant may include anionic low-molecular-weight materials, cationic high-molecular-weight materials, organic acids, etc.

The anionic low-molecular-weight material as the dispersant may be selected from the group consisting of among oxalic acid, citric acid, polysulfonic acid, polyacrylic acid, and polymethacrylic acid.

The cationic high-molecular-weight material as the dispersant may be selected from the group consisting of polylysine, polyethyleneimine, benzethonium chloride, bronidox, cetrimonium bromide, cetrimonium chloride, dimethyldioctadecylammonium chloride, tetramethylammonium hydroxide, distearyl dimethyl ammonium chloride, and polyaryl amine.

The organic acid as the dispersant may be selected from the group consisting of hydroxybenzoic acid, ascorbic acid, picolinic acid, glutamic acid, tryptophan, and aminobutyric acid.

The polishing rate enhancer is an additive for increasing the polishing rate of a substrate or wiring to be polished, and may be selected from the group consisting of potassium nitrate, iron nitrate, ammonium hydroxide, citric acid, and acetic acid.

The polishing regulator serves to minimize adsorption of the polishing composition to the metal surface and may include ammonium compounds, potassium nitrate, amino acids, salts thereof, etc.

The polishing composition may further include a pH buffer to stabilize the pH of the polishing composition. The pH buffer may include an acetic acid-based compound.

The polishing composition for a semiconductor process may include a solvent. The solvent may be water, particularly ultrapure water.

### Properties of polishing composition

The polishing selectivity of the polishing composition for a silicon oxide film relative to a tungsten film may be 1 to 5.

The polishing selectivity for a silicon oxide film relative to a tungsten film means the ratio of the polishing rate of the polishing composition for a silicon oxide film relative to the polishing rate of the polishing composition for a tungsten film.

In the present disclosure, the polishing selectivity may be controlled within the preset range described above, enabling smoother polishing of a substrate surface, on which a tungsten pattern film having a fine pitch is formed. In particular, the polishing composition with the controlled polishing selectivity may serve to suppress excessive polishing of the insulating film when polishing the substrate surface, on which a tungsten pattern film and an insulating film are formed.

When measuring the polishing selectivity or polishing rate, the polishing conditions are set to a polishing time of 60 seconds, a pressure applied to the wafer of 1.6 psi, a pressure applied to the retainer ring of 2.4 psi, a head rotation speed of 101 rpm, a table rotation speed of 100 rpm, and a slurry supply speed of 200 ml/min. An HD-500C model from SK enpulse may be used as a polishing pad. An AP-300 model from CTS may be used as a polishing machine.

The polishing selectivity of the polishing composition for a silicon oxide film relative to a tungsten film in may be 1 to 5. The polishing selectivity may be 1.3 or more. The polishing selectivity may be 1.5 or more. The polishing selectivity may be 2 or more. The polishing selectivity may be 4 or less. As such, even when the substrate surface, on which a fine tungsten pattern film is formed, is polished, it is possible to provide a polished surface with suppressed defect occurrence.

The polishing rate of the polishing composition for a silicon oxide film may be 500 Å/min or more. The polishing rate may be 700 Å/min or more. The polishing rate may be 900 Å/min or more. The polishing rate may be 1,600 Å/min or less. The polishing rate may be 1,400 Å/min or less. The polishing rate may be 1,200 Å/min or less.

The polishing rate of the polishing composition for a tungsten film may be 120 Å/min or more. The polishing rate may be 200 Å/min or more. The polishing rate may be 300 Å/min or more. The polishing rate may be 400 Å/min or more. The polishing rate may be 500 Å/min or more. The polishing rate may be 1,000 Å/min or less.

The Ra value of the tungsten film measured after polishing for 60 seconds with the polishing composition for a semiconductor process may be 3 nm or less. The Ra value may be 2 nm or less.

As such, the polishing composition may provide a substrate including a tungsten micropattern and having a smoother surface.

The Ra value is measured according to ISO 4287.

The electrical conductivity of the polishing composition for a semiconductor process may be 200 µS/cm or more. The electrical conductivity may be 250 µS/cm or more. The electrical conductivity may be 300 µS/cm or more. The electrical conductivity may be 350 µS/cm or more. The electrical conductivity may be 1,000 µS/cm or less. As such, it is possible to efficiently carry out oxidation reaction of the tungsten film. Furthermore, it is possible to polish the surface to be polished at a high polishing speed by the polishing composition.

The pH of the polishing composition for a semiconductor process may be in the range of 1.5 to 4.5. The pH may be 2 or more. The pH may be 2.5 or more. The pH may be 4 or less. As such, it is possible to improve the polishing properties of the polishing composition for the tungsten film, so that a step height between the tungsten film and the insulating film on the polished surface may be reduced to a predetermined level or less.

The pH of the polishing composition is measured using a pH meter.

The zeta potential of the polishing composition for a semiconductor process may be in the range of +5 mV to +50 mV. The zeta potential may be +10 mV or more. The zeta potential may be +40 mV or less.

The zeta potential of the polishing particles may be in the range of +5 mV to +50 mV. The zeta potential may be +10 mV or more. The zeta potential may be +40 mV or less.

As such, the polishing composition may exhibit stable dispersibility and excellent polishing properties on the substrate surface.

The polishing composition for a semiconductor process may be a polishing composition for tungsten. The polishing composition for tungsten refers to a polishing composition that is used for polishing not only a substrate, on which a tungsten film is formed alone, but also a substrate, on which a tungsten film and a film of another material are formed, namely a substrate, on which a tungsten pattern film and the like are formed.

The polishing composition for a semiconductor process may be a polishing composition for a secondary tungsten polishing process. A description of the secondary tungsten polishing process is omitted as it overlaps with that described above.

### Method of manufacturing substrate

The method of manufacturing a substrate according to the present disclosure includes polishing a substrate using the polishing composition for a semiconductor process as a slurry.

The substrate may include at least one of an insulating film, a metal wiring and a barrier layer on the upper surface of the substrate. The metal wiring may include copper or tungsten. When the metal wiring includes copper, the barrier layer may include tantalum and nitrides thereof. When the metal wiring includes tungsten, the barrier layer may include titanium and nitrides thereof.

Specifically, polishing the substrate may be performed by bringing a substrate to be polished into contact with a polishing pad together with the polishing composition supplied from a spray nozzle, while a polishing head that fixes the substrate rotates and a platen, to which the polishing pad is attached, also rotates.

Conditioning the surface of the polishing pad may be performed before polishing, as necessary.

The polishing composition for a semiconductor process may also polish a wafer that comes into contact with the polishing pad while penetrating toward the substrate.

During polishing of the substrate, a pressure of 6.89 kPa to 48.26 kPa may be applied. The pressure may be in the range of 13.79 kPa to 34.47 kPa.

Polishing the substrate may be performed for 50 seconds to 10 minutes. Here, the polishing time may vary depending on the extent of polishing intended.

A description of the polishing composition for a semiconductor process is omitted as it overlaps with that described above.

The method of manufacturing the substrate may further include cleaning the polished substrate.

The cleaning process may be performed by cleaning the polished substrate using purified water and an inert gas.

A better understanding of the present disclosure may be obtained through the following examples. These examples are merely set forth to illustrate the present disclosure and are not to be construed as limiting the scope of the present disclosure.

### Preparation Example: Preparation of the polishing composition

Example 1: A total of 100 wt% of the polishing composition was prepared by adding 3 wt% of colloidal silica surface-modified with 38 ppm (by weight) of (3-aminopropyl)triethoxysilane as polishing particles, 0.005 wt% of iron(III) nitrate enneahydrate as an iron ion compound, 0.012 wt% of propanedioic acid as an iron ion stabilizer, 0.0026 wt% of acetic acid as a pH buffer, and 0.3 wt% of hydrogen peroxide as an oxidant to ultrapure water as a solvent followed by mixing.

As the polishing particles, polishing particles subjected to two cycles of filtering were used. Specifically, a filter with a pore size of 0.1 µm from Saehan Green was used as a primary filter, a filter with a pore size of 0.07 µm from Saehan Green was used as a secondary filter, and a filter with a pore size of 0.07 µm from MYCROPORE CORPORATION was used as a tertiary filter. Filtering was performed by passing the polishing composition through the primary filter, the secondary filter, and the tertiary filter in that order. The filtering was performed twice in total to filter the polishing particles.

Example 2: A total of 100 wt% of the polishing composition was prepared under the same conditions as in Example 1, with the exception that 0.01 wt% of polyglycerin was further added as a surfactant (excluding ultrapure water by the corresponding weight).

Example 3: A total of 100 wt% of the polishing composition was prepared under the same conditions as in Example 1, with the exception that the content of the iron ion compound was changed to 0.009 wt%.

Example 4: A total of 100 wt% of the polishing composition was prepared under the same conditions as in Example 1, with the exception that the content of the iron ion compound was changed to 0.014 wt%.

Comparative Example 1: A total of 100 wt% of the polishing composition was prepared under the same conditions as in Example 1, with the exception that the iron ion compound and the iron ion stabilizer were not added.

The contents of components in the polishing composition of each of Examples and Comparative Example are shown in Table 1 below, and the average diameter of the polishing particles (diameter of primary particles) and the pH, zeta potential, and electrical conductivity of the polishing composition of Example 1 are shown in Table 2 below.

### Evaluation Example: Measurement of polishing properties

By applying the polishing composition of each of Examples and Comparative Example, a 7000 Å thick tungsten film and a 2 µm thick silicon oxide film were polished using an AP-300 polishing machine from CTS. The tungsten film and the silicon oxide film were formed on different wafers, and the diameter of the wafers was 300 mm.

The polishing conditions were set to a polishing time of 60 seconds, a pressure applied to the wafer of 2.4 psi, a pressure applied to the retainer ring of 4.1 psi, a head rotation speed of 101 rpm, a table rotation speed of 100 rpm, and a slurry supply speed of 200 ml/min. HD-500C model from SK enpulse was used as a polishing pad.

The height differences of the tungsten pattern film and the silicon oxide film before and after polishing were measured from the polished wafers, and the polishing rates of the tungsten film and the silicon oxide film and the polishing selectivity for the silicon oxide film relative to the tungsten film were calculated from the measured values.

The measured and calculated values in Examples and Comparative Example are shown in Table 3 below.

### Evaluation Example: Measurement by LPC and evaluation of defect detection

In the polishing compositions of Examples 1 and 2, the number of particles with a diameter exceeding 1 µm, the number of particles with a diameter exceeding 5 µm, and the number of particles with a diameter exceeding 10 µm were measured using a particle size analyzer, for example an AccuSizer 780 model from Entegris. When measuring the number of large particles, the polishing compositions were placed in the particle size analyzer without dilution, and the measurement conditions were set to Sensor Model LE400-05, a dilution factor of 1.53, a flow pump factor of 15 ml/min, and a sample vessel of 12 ml.

From the measured values of Examples, the number of large particles per volume of the polishing composition was calculated.

Thereafter, the wafer surface covered with a silicon oxide film was polished with the polishing composition of each of Examples 1 and 2. The polishing conditions were set to a polishing time of 60 seconds, a pressure applied to the wafer of 1.6 psi, a pressure applied to the retainer ring of 2.4 psi, a head rotation speed of 101 rpm, a table rotation speed of 100 rpm, and a slurry supply speed of 200 ml/min. An HD-500C model from SK enpulse was used as a polishing pad.

After cleaning the polished wafer surface with a brush, the number of defects detected on the wafer surface was measured.

Defect detection after polishing in each of Examples was performed twice.

The measured values of Examples are shown in Table 4 below.

### Evaluation Example: Evaluation of tungsten protrusion

The surface of a wafer, on which a tungsten pattern film and a silicon oxide film were formed, was polished using the polishing composition of Example 1. Here, the wafer with a pattern density of 50% was used.

The polishing conditions were set to a polishing time of 60 seconds, a pressure applied to the wafer of 2.4 psi, a pressure applied to the retainer ring of 4.1 psi, a head rotation speed of 101 rpm, a table rotation speed of 100 rpm, and a slurry supply speed of 200 ml/min. An HD-500C model from SK enpulse was used as a polishing pad.

After completion of polishing, the height differences of the tungsten film and the silicon oxide film before and after polishing were measured by observing the cross-section of the wafer, and the polishing rate of the silicon oxide film, the polishing rate of the tungsten film, and the polishing selectivity for the silicon oxide film relative to the tungsten film were calculated from the height differences.

The polishing rate and polishing selectivity values are shown in Table 5 below.

**[Table 1]**

| | Polishing particle content (wt%) | Iron ion compound content (wt%) | Iron ion content (wt%) | Iron ion stabilizer content (wt%) | Rs/i* | pH buffer content (wt%) | Surfactant content (wt%) | Oxidant content (wt%) |
|---|---|---|---|---|---|---|---|---|
| Example 1 | 3 | 0.005 | 0.0007 | 0.012 | 17.36 | 0.0026 | 0 | 0.3 |
| Example 2 | 3 | 0.005 | 0.0007 | 0.012 | 17.36 | 0.0026 | 0.01 | 0.3 |
| Example 3 | 3 | 0.009 | 0.0012 | 0.012 | 9.65 | 0.0026 | 0 | 0.3 |
| Example 4 | 3 | 0.014 | 0.0019 | 0.012 | 6.20 | 0.0026 | 0 | 0.3 |
| Comparative Example 1 | 3 | 0 | 0 | 0 | - | 0.0026 | 0 | 0.3 |

Rs/i: Ratio of iron ion stabilizer content (by weight) relative to iron ion content (by weight)

**[Table 2]**

| | Average diameter of polishing particles (nm) | pH | Zeta potential (mV) | Electrical conductivity (µS/cm) |
|---|---|---|---|---|
| Example 1 | 44.63 | 2.9 | 20.9 | 425 |

**[Table 3]**

| | Polishing rate of silicon oxide film (Å/min) | Polishing rate of tungsten film (Å/min) | Polishing selectivity for silicon oxide film relative to tungsten film |
|---|---|---|---|
| Example 1 | 1,036 | 450 | 2.3 |
| Example 2 | 1,040 | 463 | 2.2 |
| Example 3 | 869 | 530 | 1.6 |
| Example 4 | 631 | 604 | 1 |
| Comparative Example 1 | 1,732 | 108 | 16 |

**[Table 4]**

| | Number of particles with diameter exceedin g 1 µm (particles ) | Number of particles with diameter exceeding 1 µm per unit volume (particles/m l) | Number of particles with diameter exceedin g 5 µm (particles ) | Number of particles with diameter exceeding 5 µm per unit volume (particles/m l) | Number of particles with diameter exceedin g 10 µm (particles ) | Number of particles with diameter exceeding 10 µm per unit volume (particles/m l) | Number of defects after primary polishin g (defects ) | Number of defects after secondar y polishing (defects) |
|---|---|---|---|---|---|---|---|---|
| Exampl e 1 | 2,938 | 244.83 | 81 | 6.75 | 7 | 0.58 | 475 | 569 |
| Exampl e 2 | 334 | 27.83 | 25 | 2.08 | 5 | 0.42 | 347 | 300 |

**[Table 5]**

| | Polishing rate of silicon oxide film (Å/min) | Polishing rate of tungsten film (Å/min) | Polishing selectivity for silicon oxide film relative to tungsten film |
|---|---|---|---|
| Example 1 | 1182 | 532 | 2.2 |

Referring to Tables 1 and 3, as the content of iron ions increased, the polishing rate of the silicon oxide film decreased and the polishing rate of the tungsten film increased.

Referring to Table 4, Example 2 showed very few large particles and few defects on the polished surface compared to Example 1. This is deemed to be because the surfactant contributes to suppressing the formation of large particles in the polishing composition.

Based on results of observation of the cross-section of the polished wafer, it was found that the step height between the tungsten pattern film and the silicon oxide film was insignificant when the pattern wafer was polished with the polishing composition of Example 1.

As is apparent from the foregoing, a polishing composition for a semiconductor process according to the present disclosure is capable of smoothly polishing a substrate surface including a tungsten pattern film having a fine pitch.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

## Claims

1. A polishing composition for a semiconductor process, comprising:
polishing particles;
iron (Fe) ions; and
an iron (Fe) ion stabilizer;
wherein the iron ion stabilizer comprises two or more carboxyl groups, and
wherein the polishing composition has electrical conductivity of 200 µS/cm to 800 µS/cm.

2. The polishing composition of claim 1, wherein the iron ions are derived from a compound selected from the group consisting of iron chloride, iron nitrate, iron sulfate, iron perchlorate, iron acetate, iron citrate, and Fe(III)-EDTA (ethylenediaminetetraacetic acid).

3. The polishing composition of claim 1, wherein the iron ion stabilizer is selected from the group consisting of ethanedioic acid, propanedioic acid, butanedioic acid, pentanedioic acid, hexanedioic acid, and heptanedioic acid.

4. The polishing composition of claim 1, wherein a weight ratio of a content of the iron ion stabilizer relative to a content of the iron ions is 3 to 50.

5. The polishing composition of claim 1, wherein the polishing composition comprises 1*10⁻⁴ wt% to 5*10⁻³ wt% of the iron ions.

6. The polishing composition of claim 1, further comprising a polyglycerin-based compound.

7. The polishing composition of claim 11, wherein a weight average molecular weight of the polyglycerin-based compound is 300 g/mol to 1,200 g/mol.

8. The polishing composition of claim 11, wherein the polishing composition comprises 0.001 wt% to 0.1 wt% of the polyglycerin-based compound based on a total weight of the polishing composition.

9. The polishing composition of claim 1, wherein a polishing selectivity of the polishing composition for a silicon oxide film relative to a tungsten film is 1 to 5.

10. The polishing composition of claim 1, wherein a pH of the polishing composition is 1.5 to 4.5.

11. The polishing composition of claim 1, wherein a number of the particles having a diameter exceeding 1 µm in the polishing composition is 80/ml or less as measured by a large particle counter (LPC) per unit volume.

12. A method of manufacturing a substrate, comprising polishing the substrate using the polishing composition of claim 1 as a slurry.
